# EUROPEAN PATENT SPECIFICATION

(11) **EP 0 904 568 B1**
(45) Date of publication and mention of the grant of the patent: **11.04.2001**
(21) Application number: 97929869.2
(22) Date of filing: 06.06.1997
(51) Int. Cl.: G03F 7/09, H01L 31/0216

(54) **METAL ION REDUCTION OF AMINOAROMATIC CHROMOPHORES AND THEIR USE IN THE SYNTHESIS OF LOW METAL BOTTOM ANTI-REFLECTIVE COATINGS FOR PHOTORESISTS**
METALLIONENREDUZIERUNG VON AMINOAROMATISCHEN CHROMOPHONEN UND IHRE VERWENDUNG ZUR HERSTELLUNG VON ANTIREFLEXUNTERSCHICHTEN MIT GERINGEM GEHALT AN METALLIONEN FÜR PHOTORESISTE
REDUCTION DE LA TENEUR EN IONS METALLIQUES DE CHROMOPHORES AMINOAROMATIQUES ET LEUR UTILISATION DANS LA SYNTHESE DE REVETEMENTS DE FOND ANTIREFLECHISSANTS A FAIBLE TENEUR EN METAL POUR PHOTORESERVE

(30) Priority: 06.06.1996 US 660030
(43) Date of publication of application: 31.03.1999
(73) Proprietor: Clariant Finance (BVI) Limited, Road Town, Tortola (VG)
(72) Inventor: RAHMAN, M., Dalil, Flemington, NJ 08822 (US); HANNIGAN, Timothy, T., Basking Ridge, NJ 07920 (US); LYNCH, Thomas, J., Branchburg, NJ 08876 (US)
(74) Representative: Hütter, Klaus, Dr.
(86) International application number: US9709952
(87) International publication number: WO9746915

(56) References cited:
- EP-A- 0 583 205
- WO-A-94/12912

## Description

### BACKGROUND OF THE INVENTION

The present invention relates to a process for producing bottom anti-reflective coating solutions having a very low level of metal ions, especially sodium and iron, for photoresists and to a process for producing semiconductor devices using such bottom anti-reflective coating solutions with light-sensitive photoresist compositions . Further, the present invention relates to a process for coating substrates with these bottom anti-reflective coating solutions, then coating with a photoresist, imaging, and developing these light-sensitive photoresist compositions.

Thin film interference plays a central role in the process control of optical microlithography. Small variations in the thickness of resist or of thin films underneath the resist cause large exposure variations, which in turn cause two classes of undesirable line width variations:
1. As thin film thickness varies from run to run, wafer to wafer, or across a wafer, line widths will vary from run to run, wafer to wafer or across a wafer.
2. As patterning takes place over wafer topography, the resist thickness unavoidably changes at the topography edge causing the line width to vary as it crosses the edge

Avoiding such thin film interference effects is one of the key advantages of advanced processes such as X-Ray lithography or multi-layer resist systems. However, Single Layer Resist (SLR) processes dominate semiconductor manufacturing lines because of the their simplicity and cost-effectiveness, and also because of the relative cleanliness of wet developed processes compared with dry processes.

Thin film interference results in periodic undulations in a plot of the exposure dose required to clear positive photoresist (termed dose-to-clear) versus the photoresist thickness. Optically, on a resist-coated substrate, light reflected from the bottom mirror (due to the effect of the substrate + thin films) interferes with the reflection of the top mirror (the resist/air interface).

As optical lithography pushes towards shorter wavelengths, thin film interference effects become increasingly important. More severe swings in intensity are seen as wavelength decreases.

One strategy for reducing thin film interference is to reduce the substrate reflectivity through the use of absorptive anti-reflective coatings. One way of doing this is to apply a bottom anti-reflective coating prior to coating with the photoresist and prior to exposure.

Photoresist compositions are used in microlithography processes for making miniaturized electronic components such as in the fabrication of computer chips and integrated circuits. Generally, in these processes, a thin coating of film of a photoresist composition is first applied to a substrate material, such as silicon wafers used for making integrated circuits. The coated substrate is then baked to evaporate any solvent in the photoresist composition and to fix the coating onto the substrate. The baked coated surface of the substrate is next subjected to an image-wise exposure to radiation.

This radiation exposure causes a chemical transformation in the exposed areas of the coated surface. Visible light, ultraviolet (UV) light, electron beam and X-ray radiant energy are radiation types commonly used today in microlithographic processes. After this image-wise exposure, the coated substrate is treated with a developer solution to dissolve and remove either the radiation-exposed or the unexposed areas of the photoresist and the anti-reflective coating from the surface of the substrate. The anti-reflective coating can additionally be removed by plasma etching, where the photoresist image acts as a mask.

Metal contamination has been a problem for a long time in the fabrication of high density integrated circuits and computer chips, often leading to increased defects, yield losses, degradation and decreased performance. In plasma processes, metals such as sodium and iron, when they are present in the photoresist or in a coating on the photoresist, can cause contamination especially during plasma stripping. However, these problems have been overcome to a substantial extent during the fabrication process, for example, by utilizing HCI gettering of the contaminants during a high temperature anneal cycle.

As semiconductor devices have become more sophisticated, these problems have become much more difficult to overcome. When silicon wafers are coated with a liquid positive photoresist and subsequently stripped off, such as with oxygen microwave plasma, the performance and stability of the semiconductor device is often seen to decrease. As the plasma stripping process is repeated, more degradation of the device frequently occurs. A primary cause of such problems can be the metal contamination in the anti-reflective coating on the wafer, particularly sodium and iron ions. Metal levels of as low as 0.1 ppm can adversely affect the properties of such semiconductor devices.

There are two types of photoresist compositions, negative-working and positive-working. When negative-working photoresist compositions are image-wise exposed to radiation, the areas of the resist composition exposed to the radiation become less soluble to a developer solution (e.g. a cross-linking reaction occurs) while the unexposed areas of the photoresist coating remain relatively soluble to such a solution. Thus, treatment of an exposed negative-working resist with a developer causes removal of the non-exposed areas of the photoresist coating and the creation of a negative image in the coating. Thereby uncovering a desired portion of the underlying substrate surface on which the photoresist composition was deposited.

On the other hand, when positive-working photoresist compositions are exposed image-wise to radiation, those areas of the photoresist composition exposed to the radiation become more soluble in the developer solution (e.g. a rearrangement reaction occurs) while those areas not exposed remain relatively insoluble in the developer solution. Thus, treatment of an exposed positive-working photoresist with the developer causes removal of the exposed areas of the coating and the creation of a positive image in the photoresist coating. Again, a desired portion of the underlying substrate surface is uncovered.

After this development operation, the now partially unprotected anti-reflective coating may be treated with an etchant solution or plasma gases and the like. The etchant solution or plasma gases etch that portion of the anti-reflective coating from where the photoresist coating was removed during development. The areas of the substrate where the photoresist coating still remains are protected and, thus, an etched pattern is created in the substrate material which corresponds to the photomask used for the image-wise exposure of the radiation. Further processes, such as, etching and doping can be performed. Later, the remaining areas of the photoresist coating may be removed during a stripping operation, leaving a clean etched substrate surface. In some instances, it is desirable to heat treat the remaining photoresist layer, after the development step and before the etching step, to increase its adhesion to the underlying substrate and its resistance to etching solutions.

Positive working photoresist compositions are currently favored over negative working resists because the former generally have better resolution capabilities and pattern transfer characteristics. Photoresist resolution is defined as the smallest feature which the resist composition can transfer from the photomask to the substrate with a high degree of image edge acuity after exposure and development. In many manufacturing applications today, resist resolution on the order of less then one micron are necessary. In addition, it is almost always desirable that the developed photoresist wall profiles be near vertical relative to the substrate. Such demarcations between developed and undeveloped areas of the resist coating translate into accurate pattern transfer of the mask image onto the substrate.

### SUMMARY OF THE INVENTION

The present invention relates to a process for producing bottom anti-reflective coating solutions containing very low levels of metal ions, especially sodium and iron and to a process for producing photoimages using such coatings, where the antireflective coating solution is a reaction product of an aminoaromatic chromophore with reduced metals and a polymer comprising an anhydride. The process of this invention comprises passing a filtered solution of the aminoaromatic chromophore through a precleaned anion exchange resin and distilling off the polar solvent to obtain a material with metal level less than 100 ppb, preferably less than 50 ppb and most preferably less than 10 ppb, further reacting the aminoaromatic chromophore with a polymer containing an anhydride group and washing the product of this reaction with deionized water, removing the residual water and adjusting the solid content with the casting solvent to obtain an antireflective coating solution with metal levels of sodium and iron being less than 100 ppb each, more preferably less than 50 ppb each and most less than 10 ppb each and a solid content in the range of about 2% to about 15% by weight.. The invention further relates to a process for making semiconductor devices using such bottom anti-reflective coatings for photoresists and to semiconductor devices produced using such a process.

The process of the subject invention provides a bottom anti-reflective coating solution having a very low level of metal ions. The anti-reflective coating is applied prior to a photoresist, which may be either negative or positive working, although positive photoresists are preferred.

### DETAILED DESCRIPTION OF THE PREFERRED EMBODIMENTS

The present invention provides a process for producing a bottom anti-reflective coating solution having a very low level of metal ions, particularly sodium and iron, and further a process for producing semiconductor devices using such a bottom anti-reflective coating. The instant invention describes a novel process which utilizes an anion exchange resin to purify the aminoaromatic chromophore and the reaction of this chromophore with a polymer to give an antireflective coating with very low levels of metal ions.

The anti-reflective coating utilized in this invention comprises a film forming composition comprising the imide reaction product of at least one aminoaromatic chromophore with a polymer comprising an anhydride. The aminoaromatic chromophore may be any aromatic compound having a primary or secondary amino moiety linked thereto and may be an N-aryl amino compound, a benzyl amine, or another aminoaromatic compound wherein the amino group is linked to the aromatic compound by means of an intermediate group. Preferred amino aromatic chromophores have a primary amino group. More preferred aminoaromatic chromophores have a primary amino group linked to the aromatic compound by means of a N-aryl bond. The most preferred aminoaromatic chromophores are selected from the group consisting of 1-aminoanthracene, 2-aminoanthracene, 1-aminonaphthalene, 2-aminonaphthalene, N-(2,4-dinitrophenyl)-1,4-benzenediamine, p-(2,4-dinitrophenylazo) aniline, p-(4-N,N-dimethylaminophenylazo)aniline, 4-amino-2-(9-(6-hydroxy-3-xanthenonyl)-benzoic acid, 2,4-dinitrophenylhydrazine, dinitroaniline, aminobenzothiazoline, and aminofluorenone. Polymers useful for reacting with the aminoaromatic chromophore comprise any polymer having an anhydride group. Particular examples include, without limitation, polydimethyglutarimide, poly(maleic anhydride-co-methylmethacrylate), poly(maleic anhydride-co-vinylmethylether), poly(styrene-co-maleic anhydride), and poly(acrylic anhydride), and derivatives, copolymers and combinations thereof.

The antireflective coating utilized in this invention may be dissolved in various solvents ( hereafter referred to as casting solvent) to provide a composition which is useful for forming thin films. Particular examples of solvents include, without limitation, butyrolactone, cyclopentanone, cyclohexanone, dimethyl acetamide, dimethylformamide, dimethyl sulfoxide, N-methyl pyrrolidone, tetrahydrofurfural alcohol, or combinations thereof. The preferred solvents are butyrolactone, cyclopentanone, and cyclohexanone. Additives, such as surfactants may also be added at low levels to improve coating properties, for example, 3M Fluorad® FC-430.

The subject process of this invention comprises:
(a)
   1. making a solution of an aminoaromatic chromophore in an electronic grade casting solvent, such as cyclohexanone or cyclopentanone;
   2. adding an electronic grade polar solvent, such as a low boiling point, polar organic solvent like acetone, methanol, ethanol or propanol, to make a homogenous solution, where the ratio of electronic grade casting solvent to electronic grade polar solvent is in the range of about 1:0.2 to about 1:3;
   3. filtering the solution, such as through a Teflon® filter (polytetrafluoroethylene);
   4. passing the filtered solution through a prewashed anion exchange resin, such as Amberlyst® A21 or BioRad® column at a rate so that the residence time is sufficient to reduce the level of sodium and iron ions to less 50 ppb each, preferably less than 20 ppb each, most preferably less than 5 ppb each;
   5. distilling off the electronic grade polar solvent to give a low metal solution with sodium and iron ion levels of less than 100 ppb each, preferably less than 50 ppb each, most preferably less than 10 ppb each; or
   alternatively,
   1. making a solution of an aminoaromatic chromophore in an electronic grade polar solvent, such as a low boiling point, polar organic solvent like acetone, methanol, ethanol or propanol;
   2. filtering the solution, such as through a Teflon® filter (polytetrafluoroethylene);
   3. passing the filtered solution through a prewashed anion exchange resin, such as Amberlyst® 21 or BioRad® column at a rate so that the residence time is sufficient to reduce the level of sodium and iron ions to less 50 ppb each, preferably less than 20 ppb each, most preferably less than 5 ppb each ;
   4. adding an electronic grade casting solvent, such as cyclohexanone or cyclopentanone, where the ratio of electronic grade casting solvent to electronic grade polar solvent is in a range of about 1:0.2 to about 1:3;
   5. distilling off the electronic grade polar solvent to give a low metal solution with sodium and iron ions levels less than 100 ppb each, preferably less than 50 ppb each, most preferably less than 10 ppb each, to give a low metal solution;
b) reacting the low metal solution and a polymer with an anhydride group at a temperature between about 120°C to 160°C for about 6-8 hours, to give a reaction product with a gpc (gel permeation chromatograph) weight average molecular weight of from about 50,000 to about 2,000,000;
c) adding deionized water to the reaction product, stirring for about 30-90 minutes, decanting the water layer, distilling to remove residual water and, if needed, adjusting the solid content of the reaction product with the electronic grade casting solvent to produce a bottom antireflective coating solution having sodium and iron ions less than 100 ppb each, preferably less than 50 ppb each and most preferably less than 10 ppb each and a solid content of from about 2% to about 15% by weight, preferably 3-10% by weight, and most preferably 4 to 8% by weight.

Prior to the anion exchange resin treatment of the individual aminochromatic chromophore (dye) or the copolymer component, the anion exchange resin is treated with a solvent which is the same as or at least compatible with the solvent for the component or mixture of components which is to be treated with the anion exchange resin. Most preferably, the anion exchange resin is treated with sufficient new solvent to substantially remove other solvents and to saturate the ion exchange resin with the new solvent.

An anion exchange resin, such as a styrene/divinylbenzene anion exchange resin, is preferably utilized in the present process. Such anion exchange resins are available from Rohm and Haas Company, e.g. Amberlyst^{®} A-21, A-26 or A-27 resin or from BioRad Corporation. These resins typically contain as much as 80,000 to 200,000 ppb or more of sodium and iron. Before being utilized in the process of the invention, the anion exchange resin must be prewashed by washing with deionized water and then with an ammonium hydroxide solution. Preferably, the anion exchange resin is initially rinsed with deionized water, followed by an ammonum hydroxide solution and rinsed again with deionized water until the rinse water has an 18 mega ohm conductivity.

The present invention also provides a process for producing semiconductor devices using such anti-reflective coatings and semiconductor devices produced using such a process. The subject process comprises:
(a)
   1. making a solution of an aminoaromatic chromophore in an electronic grade casting solvent, such as cyclohexanone or cyclopentanone;
   2. adding an electronic grade polar solvent, such as a low boiling point, polar organic solvent like acetone, methanol, ethanol or propanol, to make a homogenous solution, where the ratio of electronic grade casting solvent to electronic grade polar solvent is in the range of about 1:0.2 to about 1:3;
   3. filtering the solution, such as through a Teflon® filter (polytetrafluoroethylene);
   4. passing the filtered solution through a prewashed anion exchange resin, such as Amberlyst® A21 or BioRad® column at a rate so that the residence time is sufficient to reduce the level of sodium and iron ions to less 50 ppb each, preferably less than 20 ppb each, most preferably less than 5 ppb each;
   5. distilling off the electronic grade polar solvent to give a low metal solution with sodium and iron ion levels of less than 100 ppb each, preferably less than 50 ppb each, most preferably less than 10 ppb each; or
   alternatively,
   1. making a solution of an aminoaromatic chromophore in an electronic grade polar solvent, such as a low boiling point, polar organic solvent like acetone, methanol, ethanol or propanol;
   2. filtering the solution, such as through a Teflon® filter (polytetrafluoroethylene);
   3. passing the filtered solution through a prewashed anion exchange resin, such as Amberlyst® 21 or BioRad® column at a rate so that the residence time is sufficient to reduce the level of sodium and iron ions to less 50 ppb each, preferably less than 20 ppb each, most preferably less than 5 ppb each;
   4. adding an electronic grade casting solvent, such as cyclohexanone or cyclopentanone, where the ratio of electronic grade casting solvent to electronic grade polar solvent is in a range of about 1:0.2 to about 1:3;
   5. distilling off the electronic grade polar solvent to give a low metal solution with levels of sodium and iron ions of less than 100 ppb each, preferably less than 50 ppb each, most preferably less than 10 ppb each;
(b) reacting the low metal solution and a polymer with an anhydride group at a temperature between about 120°C to 160°C for about 6-8 hours, to give a reaction product with a gpc (gel permeation chromatograph) weight average molecular weight of from about 50,000 to about 2,000,000;
(c) adding deionized water to the reaction product, stirring for about 30-90 minutes, decanting the water layer, distilling to remove residual water and, if needed, adjusting the solid content of the reaction product with the electronic grade casting solvent to produce a bottom antireflective coating solution having levels of sodium and iron ions less than 100 ppb each, preferably less than 50 ppb each and most preferably less than 10 ppb each and a solid content of from about 2% to about 15% by weight, preferably 3%to 10% by weight, and most preferably 4% to 8% by weight;
(d) formulating a photoresist composition solution by providing an admixture of:
   1. a photosensitive component in an amount sufficient to photosensitize the photoresist composition,
   2. a water insoluble, aqueous alkali soluble film forming novolak resin in an amount sufficient to form a substantially uniform photoresist composition, and
   3. a suitable photoresist solvent;
(e) first coating a suitable substrate with the bottom anti-reflective composition from (c);
(f) heating the substrate at a temperature sufficient to substantially remove the electronic grade casting solvent;
(g) coating the substrate with the photoresist composition;
(h) heat treating the coated substrate until substantially all of the photoresist solvent is removed; image-wise exposing the photoresist composition and developing the photoresist composition with a suitable developer, such as an aqueous alkaline developer;
(i) optionally heating the substrate either immediately before or after the developing step of (h).

The treated bottom anti-reflective coating solution of the present invention can be applied to a substrate by any conventional method used in the photoresist art, including dipping, spraying, whirling and spin coating. When spin coating, for example, the coating solution can be adjusted with respect to the percentage of solids content, in order to provide coating of the desired thickness, given the type of spinning equipment utilized and the amount of time allowed for the spinning process. Suitable substrates include silicon, aluminum, polymeric resins, silicon dioxide, doped silicon dioxide, silicon nitride, tantalum, copper, polysilicon, ceramics, aluminum/copper mixtures; gallium arsenide and other such Group III/V compounds.

The bottom anti-reflective coatings produced by the present invention are particularly suitable for application to thermally grown silicon/silicon dioxide coated wafers, such as are utilized in the production of microprocessors and other miniaturized integrated circuit components. An aluminum/aluminum oxide wafer can also be used. The substrate may also comprise various polymeric resins, especially transparent polymers such as polyesters. The substrate may have an adhesion promoted layer of a suitable composition, such as one containing a hexa-alkyl disilazane.

The bottom anti-reflective coating of the present invention is coated onto a suitable substrate and heated at a temperatue from about 80°C to about 240°C to substantially remove the casting solvent, the substrate is then coated with a photoresist composition and the substrate is then treated at a temperature from about 70°C to about 120°C for from about 30 seconds to about 180 seconds on a hot plate or for from about 15 minutes to about 90 minutes in a convection oven. This temperature treatment is selected in order to reduce the concentration of residual solvents in the photoresist and anti-reflective coating, while not causing substantial thermal degradation of the photosensitizer.

In general, one desires to minimize the concentration of solvents in both the anti-reflective coating and the photoresist and the temperature treatments are conducted until substantially all of the solvents have evaporated and a thin coating of photoresist composition, about one micrometer (micron) in thickness, remains on the substrate. In a preferred embodiment the temperature is from about 80°C to about 120°C. The treatment is conducted until the rate of change of solvent removal becomes relatively insignificant. The temperature and time selection depends on the photoresist properties desired by the user, as well as the equipment used and commercially desired coating times. The coating substrate can then be exposed to actinic radiation, e.g., ultraviolet radiation, at a wavelength of from about 300 nm to about 450 nm, x-ray, electron beam, ion beam or laser radiation, in any desired pattern, produced by use of suitable masks, negatives, stencils, templates, etc.

The photoresist solution used to spin coat the photoimageable layer on top of the anti-reflective coating comprises an alkali-soluble, water insoluble film forming resin, a photosensitive compound and a solvent. Typical alkali-soluble resins are novolacs and polyhydoxystyrenes. Typical photosensitive compounds are diazonaphthoquinones which are obtained by reacting 2,1,5, and/or 2,1,4 naphthoquinone diazides with polyhydroxyphenolic compounds. Multihydroxybenzophenones, multihydroxyphenyl alkanes and phenolic oligomers are examples of the many types of ballast groups used. Additionally, the diazo compounds can be reacted with alkali-soluble resins. Solvents, such as propylene glycol mono-methyl ether acetate, propylene glycol mono-alkyl ether, ethylene gylcol monoethyl ether acetate, ethyl lactate, ethyl ethoxy propionate, 2-heptanone, butyl acetate, xylene, diglyme or mixtures of solvents can be used. Additives can also be incorporated into the photoresist composition e.g. dyes, dissolution inhibitors, anti-striation additives, photospeed enhancers, photoresist stabilizers, etc. The anti-reflective coating can also be coated with deep uv photoresists. Typically, these photoresists comprise a photoacid generator, a resin, a dissolution inhibitor and a solvent. The resin could be a water-insoluble and alkali-soluble polymer, such as polyvinylphenol, novolak or copolymers thereof. Another well known deep uv photoresist system comprises a photoacid generator, a resin and a solvent. The resin in this case is polymer, such as polyvinylphenol or its copolymers, that has been capped with a group that is capable of being cleaved in the presence of an acid.

The substrate is then optionally subjected to a post exposure second baking or heat treatment either before or after development. The heating temperatures may range from about 90°C to about 120°C, more preferably from about 95°C to about 120°C. The heating may be conducted for from about 30 seconds to about 2 minutes, more preferably from about 60 seconds to about 90 seconds, on a hot plate or about 30 minutes to about 45 minutes in a convection oven.

The exposed anti-reflective coating/photoresist-coated substrates are then developed to remove the image-wise exposed areas of the photoresist by immersion in a developing solution, such as an aqueous alkaline solution, or developed by a spray development process. The solution is preferably agitated, for example, by nitrogen burst agitation. The substrates are allowed to remain in the developer until all, or substantially all, of the photoresist coating has dissolved from the exposed areas. Developers may include aqueous solutions of ammonium hydroxides. One preferred hydroxide is tetramethyl ammonium hydroxide. After removal of the coated wafers from the developing solution, one may conduct an optional post-development heat treatment or bake to increase the coating's adhesion and chemical resistance to etching solutions and other substances. The post-development heat treatment can comprise the oven baking of the coating and substrate below the coating's softening point. In industrial applications, particularly in the manufacture of microcircuitry units on silicon/silicon dioxide-type substrates, the developed substrates may be treated with a buffered, hydrofluoric acid base etching solution.

The following specific examples will provide detailed illustrations of the methods of producing and utilizing compositions of the present invention. These examples are not intended, however, to limit or restrict the scope of the invention in any way and should not be construed as providing conditions, parameters or values which must be utilized exclusively in order to practice the present invention.

### Example 1

Amberlyst® 21 anion exchange resin beads were placed in a conical flask and deionized water was added so that all of the resin beads were under water. The flask was sealed and allowed to stand overnight to swell the resin beads. The next morning the water was decanted, deionized water added to cover the resin beads and the flask was shaken slowly. The water was again decanted. The rinsing with deionized water and decanting steps were repeated three more times. The resulting slurry of ion exchange resin was poured into a glass column equipped with a porous disk and a stopcock. The resin was allowed to settle to the bottom and the column was back flushed with deionized water for 25 minutes. The resin was again allowed to settle to the bottom.

The bed length was measured and the bed volume was calculated as 98 ml. A 10 weight percent sulfuric acid solution was passed down through the resin bed at a rate of about 10 ml./min so that the residence time was 12 minutes. 6 bed volumes of the acid solution were passed through the resin bed. 6 bed volumes of deionized water were then passed down through the resin bed at about the same flow rate. 6 bed volumes of electronic grade ammonium hydroxide solution (6 weight%) was passed through the column at the same rate as above followed by enough deionized (DI) water to remove excess ammonium hydroxide. The pH of the effluent water was measured to assure that it matched the pH of 6 for fresh deionized water and the conductivity of the effluent was 18 megaohms. Two bed volumes of electronic grade methanol were passed through the column at the same rate as above to remove water.

A solution of Disperse Yellow -9( 2,4 Dinitrophenyl 1,4 Benzene Diamine) was made in acetone (60.0 grams in 400 grams of acetone, 6-8 weight%) in a beaker. A sample was taken for a metal ions test (control). The solution was filtered through a 0.1 µm(micrometer) Teflon® filter(polytetrafluoroethylene) and a sample was taken for a metal ions test. The filtered solution was passed through a precleaned Amberlyst® 21, an anion exchange column at a rate so that the residence time was 12 minutes (Residence Time=Bed volume/Rate of flow, Column media was acetone, making sure there was no channeling). A sample was taken for a metal ions test. The deionized material was transfered to a flask(clean and metal ion free) equipped with a vacuum distillation set up. An equal amount of cyclohexanone was added and acetone was distilled under vacuum. All the samples were tested for metal ions and the results are shown in Table 1 below.

**Table 1**

| Metals | DY-9 in acetone (ppb) | After 0.1 µm (micrometers) filteration (ppb) | After passing through A-21 column (ppb) | After Distillation in Cyclohexanone (ppb) |
|---|---|---|---|---|
| Na | 437 | 92 | 7 | 12 |
| Fe | 178 | 150 | <5 | 15 |

### Example 2

Amberlyst® 21 anion exchange resin beads were placed in a conical flask and deionized water was added so that all of the resin beads were under water. The flask was sealed and allowed to stand overnight to swell the resin beads. The next morning the water was decanted, deionized water was added to cover the resin beads and the flask was shaken slowly. The water was again decanted. The rinsing with deionized water and the decanting steps were repeated three more times. The resulting slurry of anion exchange resin was poured into a glass column equipped with a porous disk and a stopcock. The resin was allowed to settle to the bottom and the column was back flushed with deionized water for 25 minutes. The resin was again allowed to settle to the bottom.

The bed length was measured and the bed volume was calculated as 162 ml. A 10 weight percent sulfuric acid solution was passed down through the resin bed at a rate of about 10 ml./min so that the residence time was 12 minutes. 6 bed volumes of the acid solution were passed through the resin bed. 6 bed volumes of deionized water were then passed down through the resin bed at about the same flow rate. 6 bed volumes of electronic grade ammonium hydroxide solution (6 weight%) were passed through the column at the same rate as above followed by enough DI water to remove excess ammonium hydroxide. The pH of the effluent water was measured to assure that it matched the pH of 6 for fresh deionized water. Two bed volumes of electronic grade methanol were passed through the column at the same rate as above to remove the water.

A solution of Disperse Yellow -9 was made in cyclohexanone (24.15 grams in 376.5 grams cyclohexanone) and an equal amount of acetone was added in a beaker. A sample was taken for a metal ions test (control). The solution was filtered through a 0.1 µm Teflon® filter and a sample was taken for a metal ions test. The filtered solution was passed through a precleaned Amberlyst® 21 column at a rate so that the residence time was 12 minutes(Residence Time=Bed volume/Rate of flow. Column media was acetone, making sure there was no channeling). A samples was taken for a metal ions test. The deionized material was transfered to a flask(clean and metals free) equipped with a vacuum distillation set up. Acetone was distilled off under vacuum. All the samples were tested for metal ions and the results are shown in Table 2 below.

**Table 2.**

| Metals | DY-9 in cyclohexanone /acetone (ppb) | After 0.1 µm (micrometers) filteration (ppb) | After passing through A-21 column (ppb) | After Distillation in Cyclohexanone (ppb) |
|---|---|---|---|---|
| Na | 437 | 158 | 11 | 11 |
| Fe | 178 | 92 | 7 | 11 |

### Example 3

Amberlyst® 21 anion exchange resin beads were placed in a conical flask and deionized water was added so that all of the resin beads were under water. The flask was sealed and allowed to stand overnight to swell the resin beads. The next morning the water was decanted, deionized water added to cover the resin beads and the flask was shaken slowly. The water was again decanted. The rinsing with deionized water and the decanting steps were repeated three more times. The resulting slurry of anion exchange resin was poured into a glass column equipped with a porous disk and a stopcock. The resin was allowed to settle to the bottom and the column was back flushed with deionized water for 25 minutes. The resin was again allowed to settle to the bottom.

The bed length was measured and the bed volume was calculated as 98 ml. A 10 weight percent sulfuric acid solution was passed down through the resin bed at a rate of about 10 ml./min so that the residence time was 12 minutes. 6 bed volumes of the acid solution were passed through the resin bed. 6 bed volumes of deionized water were then passed down through the resin bed at about the same flow rate. 6 bed volumes of electronic grade ammonium hydroxide solution (6 weight%) were passed through the column at the same rate as above followed by enough DI water to remove excess ammonium hydroxide. The pH of the effluent water was measured to assure that it matched the pH of 6 for fresh deionized water and the conductivity of the effluent was 18 megaohms. Two bed volumes of electronic grade methanol were passed through the column at the same rate as above to remove the water.

A solution of Disperse Yellow -9 was made in acetone (60.0 grams in 400 grams of acetone, 6-8 weight%) in a beaker. A sample was taken for a metal ions test (control). The solution was filtered through a 0.1 µm Teflon® filter and a sample was taken for a metal ions test. The filtered solution was passed through a precleaned Amberlyst® 21 column at a rate so that the residence time was 12 minutes(Residence Time=Bed volume/Rate of flow, Column media was acetone, making sure there was no channeling). A sample was taken for a metal ions test.

The deionized material was transfered to a flask(clean and metal ion free) equipped with a vacuum distillation set up. An equal amount of cyclohexanone was added and acetone was distilled under vacuum to obtain Disperse Yellow -9 (6% solid) having both sodium and iron ions less than 5 ppb. 170 grams of Disperse Yellow-9 (6% solid) and 5.5 grams of Gantrez (solid, a copolymer methylvinyl ether and maleic anhydride) were mixed for 12 hours at 20-25°C and then heated for 8 hours at 140°C. The reaction mixture was extracted with DI water 3 times and the residual water was distilled off under vacuum to obtain a bottom antireflecting coating solution having sodium and iron ions less than 20 ppb.

### Example 4

A wafer was coated with bottom antireflective coating solution from Example 3 and heated to give a film with a thickness of 0.25µm (micrometers). The wafer was coated with a 1.08µm (micrometers) film of AZ® 7700 photoresist (available from AZ Photoresist Products, Hoechst Celanese Corp). It was soft baked at 90°C for 90 secs. The wafer was then exposed through a mask with Nikon® 0.54 NA i-line stepper and developed for 70 sec by spray puddle with AZ® 300 MIF developer(available from AZ Photoresist Products, Hoechst Celanese Corp). Another wafer was coated with 1.08 µm (micrometers) AZ®7700 (available from AZ Photoresist Products, Hoechst Celanese Corp), but without the anti-reflective coating, as control. The lithographic data are listed in Table 3 below. The desired functional lithographic characteristics of the bottom anti-reflective coating are maintained with the use of the metal reduction process of the instant invention.

**Table 3**

| Wafers | AZ® 7700 (Control) | AZ® 7700 with Bottom antireflective coating |
|---|---|---|
| Amplitude (mJ/cm²) | 30.31 | 1.01 |
| Minimum F.T(µm) | 1.125 | 1.119 |
| Energy(mJ/cm²) | 171.84 | 121.40 |
| Maximum F.T(µm) | 1.181 | 1.176 |
| Energy(mJ/cm²) | 235.28 | 126.08 |
| Swing Ratio(%) | 27.01 | 3.70 |

Both Amplitude and Swing Ratio determine the variation in exposure energy with change in film thickness of the resist. Minimun variation is desireable.

## Claims

1. A process for producing a bottom anti-reflective coating composition having very low levels of metal ions comprising the steps of:
(a)
1. making a solution of an aminoaromatic chromophore in an electronic grade casting solvent;
2. adding an electronic grade polar solvent to make a homogenous solution, where the ratio of electronic grade casting solvent to electronic grade polar solvent is in the range of about 1:0.2 to about 1:3;
3. filtering the homogenous solution;
4. passing the filtered solution through a prewashed anion exchange resin, at a rate so that the residence time is sufficient to reduce the level of sodium and iron ions to less 50 ppb each;
5. distilling off the electronic grade polar solvent to give a low metal solution with sodium and iron ion levels of less than 100 ppb each;
(b) reacting the low metal solution and a polymer with an anhydride group at a temperature between about 120°C to 160°C for about 6-8 hours, to give a reaction product with a weight average molecular weight of from about 50,000 to about 2,000,000; and
(c) adding deionized water to the reaction product, stirring for about 30-90 minutes, decanting the water layer, distilling to remove residual water and thereby producing a bottom antireflective coating composition having levels of sodium and iron ions less than 100 ppb each.

2. A process for producing a bottom anti-reflective coating composition having a very low level of metal ions comprising the steps of:
(a)
1. making a solution of an aminoaromatic chromophore in an electronic grade polar solvent;
2. filtering the solution;
3. passing the filtered solution through a prewashed anion exchange resin at a rate so that the residence time is sufficient to reduce the level of sodium and iron ions to less 50 ppb each;
4. adding an electronic grade casting solvent, where the ratio of electronic grade casting solvent to electronic grade polar solvent is in a range of about 1:0.2 to about 1:3;
5. distilling off the electronic grade polar solvent to give a low metal solution with levels of sodium and iron ions of less than 100 ppb each;
(b) reacting the low metal solution and a polymer with an anhydride group at a temperature between about 120°C to 160°C for about 6-8 hours, to give a reaction product with a weight average molecular weight of from about 50,000 to about 2,000,000; and
(c) adding deionized water to the reaction product, stirring for about 30-90 minutes, decanting the water layer, distilling to remove residual water and thereby producing a bottom antireflective coating composition having levels of sodium and iron ions less than 100 ppb each.

3. The process of claim 1 or 2 wherein the level of sodium and iron ions in the ion exchange resin is reduced to less than 50 ppb each.

4. The process of claim 1 or 2 wherein the level of sodium and iron ions in the ion exchange resin is reduced to less than 10 ppb each.

5. The process of claim 1 or 2 wherein the level of sodium and iron ions in the bottom anti-reflective coating composition is reduced to less than 100 ppb each.

6. The process of claim 1 or 2 wherein the level of sodium and iron ions in the bottom anti-reflective coating composition is reduced to less than 50 ppb each.

7. The process of claim 1 or 2 wherein the level of sodium and iron ions in the bottom anti-reflective coating solution is reduced to less than 10 ppb each.

8. The process of claim 1 or 2 wherein the amonoaromatic chromophore is selected from a group consisting of 1-aminoanthracene, 2-aminoanthracene, 1-aminonaphthalene, 2-aminonaphthalene, N-(2,4-dinitrophenyl)-1,4-benzenediamine, p-(2,4-dinitrophenylazo) aniline, p-(4-N,N-dimethylaminophenylazo)aniline, 4-amino-2-(9-(6-hydroxy-3-xanthenonyl)-benzoic acid, 2,4-dinitrophenylhydrazine, dinitroaniline, aminobenzothiazoline, and aminofluorenone.

9. The process of claim 1 or 2 where the polymer is selected from a group consisting of polydimethyglutarimide, poly(maleic anhydride-co-methylmethacrylate), poly(maleic anhydride-co-vinylmethylether), poly(styrene-co-maleic anhydride), and poly(acrylicanhydride), and derivatives, copolymers and combinations thereof.

10. The process of claim 1 or 2 wherein the aminochromatic chromophore is 2,4,dinitrophenyl 1,4 benzene diamine.

11. The process of claim 1 or 2 wherein the polymer is a copolymer of methylvinylether and maleic anhydride.

12. The process of claim 1 or 2 wherein the electronic grade casting solvent is selected from a group consisting of cyclohexanone, cyclopentanone and butyrolactone.

13. The process of claim 1 or 2 wherein the electronic grade polar solvent is selected from a group consisting of acetone, methanol, ethanol and propanol.

14. The process further comprising the steps of coating the bottom anti-reflective coating from claim 1 or 2 on a substrate and heating the substrate to substantially remove the electronic grade casting solvent.

15. The process of claim 14 further comprising heating said coated substrate from a temperature of about 80°C to about 150°C.

16. A process for producing a semiconductor device by producing a photoimage on a substrate comprising the steps of:
(a)
1. making a solution of an aminoaromatic chromophore in an electronic grade casting solvent;
2. adding an electronic grade polar solvent to make a homogenous solution where the ratio of electronic grade casting solvent to electronic grade polar solvent is in the range of about 1:0.2 to about 1:3;
3. filtering the homogenous solution;
4. passing the filtered solution through a prewashed anion exchange resin, at a rate so that the residence time is sufficient to reduce the level of sodium and iron ions to less 50 ppb each;
5. distilling off the electronic grade polar solvent to give a low metal solution with levels of sodium and iron ions less than 100 ppb each;
(b) reacting the low metal solution and a polymer with an anhydride group at a temperature between about 120°C to 160°C for about 6-8 hours, to give a product with a weight average molecular weight of from about 50,000 to about 2,000,000;
(c) adding deionized water to the reaction product, stirring for about 30-90 minutes, decanting the water layer, distilling to remove residual water and thereby producing a bottom antireflective coating solution having levels of sodium and iron ions less than 100 ppb each;
(d) formulating a photoresist composition solution by providing an admixture of:
1. a photosensitive component in an amount sufficient to photosensitize the photoresist composition,
2. a film forming resin in an amount sufficient to form a substantially uniform photoresist composition, and
3. a photoresist solvent;
(e) first coating a substrate with the bottom anti-reflective coating composition from (c);
(f) heating the substrate at a temperature sufficient to substantially remove the electronic grade casting solvent;
(g) coating the substrate with the photoresist composition;
(h) heat treating the coated substrate until substantially all of the photoresist solvent is removed, image-wise exposing the photoresist composition and developing the photoresist composition with a developer; and
(i) optionally heating the substrate either immediately before or after the developing step of (h).

17. The process for producing a semiconductor by producing a photoimage on a substrate comprising the steps of:
(a)
1. making a solution of an aminoaromatic chromophore in an electronic grade polar solvent;
2. filtering the solution;
3. passing the filtered solution through a prewashed anion exchange resin at a rate so that the residence time is sufficient to reduce the level of sodium and iron ions to less than 50 ppb each;
4. adding an electronic grade casting solvent, where the ratio of electronic grade casting solvent to electronic grade polar solvent is in a range of about 1:0.2 to about 1:3;
5. distilling off the electronic grade polar solvent to give a low metal solution with levels of sodium and iron ions less than 100 ppb each;
(b) reacting the low metal solution and a polymer with an anhydride group at a temperature between about 120°C to 160°C for about 6-8 hours, to give a reaction product with a weight average molecular weight of from about 50,000 to about 2,000,000;
(c) adding deionized water to the reaction product, stirring for about 30-90 minutes, decanting the water layer, and distilling to remove residual water and thereby producing a bottom antireflective coating composition having a level of sodium and iron ions less than 100 ppb each;
(d) formulating a photoresist composition solution by providing an admixture of:
1. a photosensitive component in an amount sufficient to photosensitize the photoresist composition,
2. a film forming resin in an amount sufficient to form a substantially uniform photoresist composition, and
3. a photoresist solvent;
(e) first coating a substrate with the bottom anti-reflective coating composition from (c);
(f) heating the substrate at a temperature sufficient to substantially remove the electronic grade casting solvent;
(g) coating the substrate with the photoresist composition;
(h) heat treating the coated substrate until substantially all of the photoresist solvent is removed, image-wise exposing the photoresist composition and developing the photoresist composition with developer; and
(i) optionally heating the substrate either immediately before or after the developing step of (h).

18. The process of claim 16 or 17 further comprising heating said coated substrate from a temperature of from about 90°C to about 150°C for from about 30 seconds to about 180 seconds on a hot plate or from about 15 minutes to about 40 minutes in an oven after the exposure step but before the developing step.

19. The process of claim 16 or 17 further comprising heating said coated substrate at a temperature of from about 90°C to about 150°C for about 30 seconds to about 180 seconds on a hot plate or for from about 15 minutes to about 40 minutes in an oven after the developing step.

20. The process of claim 16 or 17 wherein said substrate comprises one or more components selected from the group consisting of silicon, aluminum, polymeric resins, silicon dioxide, doped silicon dioxide, silicon nitride, tantalum, copper and polysilicon.

21. The process of claim 16 or 17 wherein the film-forming resin in the photoresist composition is a novolak resin and amount in the photoresist composition ranges from about 70 percent to about 90 percent, based on the weight of solids.

22. The process of claim 16 or 17 wherein the photosensitive component is an ester of an alcoholic or phenolic residue and a sulfonic acid or sulfonic acid derivative.

23. The process of claim 16 or 17 wherein the photosensitive component is sensitive to radiation in the range of about 200 nm to about 450 nm.

24. The process of claim 16 or 17 wherein the photosensitive component is a naphthoquinone diazide ester of a compound selected from a group consisting of multihydroxybenzophenone, multihydroxyphenylalkane, phenolic oligomers, and mixtures thereof.

25. The process of claim 16 or 17 wherein the film forming resin is a reaction product of formaldehyde and one or more multi-substituted phenols.

26. The process of claim 16 or 17 wherein the film-forming resin in the photoresist composition is a polyhydroxystyrene or its derivatives.

27. The process of claim 16 or 17 wherein the solvent is selected from the group consisting of propylene glycol mono-alkyl ether, propylene glycol methyl ether acetate, ethyl-3-ethoxypropionate, ethyl lactate, mixtures of ethyl-3-ethoxypropionate and ethyl lactate, mixtures of ethyl-3-ethoxypropionate and ethyl lactate, butyl acetate, xylene, diglyme and ethylene glycol monoethyl ether acetate.

28. The process of claim 16 or 17 wherein the solvent comprises propylene glycol monomethyl ether acetate or ethyl-3-ethoxy propionate.

## Patentansprüche

1. Verfahren zur Herstellung einer reflexionsvermindernden Grundbeschichtungszubereitung mit einem sehr niedrigen Gehalt an Metallionen, das aus folgenden Schritten besteht:
(a)
1. Herstellung einer Lösung eines aminoaromatischen Chromophors in einem Gießlösungsmittel mit einem Reinheitsgrad für elektronische Geräte;
2. Zugabe eines polaren Lösungsmittels mit einem Reinheitsgrad für elektronische Geräte zur Herstellung einer homogenen Lösung, wobei das Verhältnis zwischen dem genannten Gießlösungsmittel und dem genannten polaren Lösungsmittel im Bereich von ca. 1:0,2 bis ca. 1:3 liegt;
3. Filtrieren der homogenen Lösung;
4. Leiten der filtrierten Lösung durch ein vorher gewaschenes Anionenaustauscherharz, wobei die Fließgeschwindigkeit so gewählt wird, daß die Verweildauer der Lösung im Harz zu einer Herabsetzung des Gehalts an Natrium- und Eisenionen auf jeweils unter 50 ppb führt;
5. Abdestillieren des polaren Lösungsmittels mit einem Reinheitsgrad für elektronische Geräte zur Herstellung einer Lösung mit einem geringen Metallgehalt, deren Natrium- und Eisenionenkonzentration unter jeweils 100 ppb liegt;
(b) ca. sechs- bis achtstündiges Umsetzen der Lösung mit dem geringen Metallgehalt und eines eine Anhydridgruppe enthaltenden Polymers bei einer Temperatur von ca. 120°C bis 160°C zur Herstellung eines Reaktionsprodukts mit einer massegemittelten Molekülmasse von ca. 50 000 bis ca. 2 000 000 und
(c) Versetzen des Reaktionsprodukts mit entionisiertem Wasser, ca. 30- bis 90-minütiges Rühren, Abgießen der Wasserschicht und Abdestillieren des Restwassers, wobei eine reflexionsvermindernde Grundbeschichtungszubereitung mit einem Gehalt an Natrium-und Eisenionen unter jeweils 100 ppb entsteht.

2. Verfahren zur Herstellung einer reflexionsvermindernden Grundbeschichtungszubereitung mit einem sehr niedrigen Gehalt an Metallionen, das aus folgenden Schritten besteht:
(a) 1. Herstellung einer Lösung eines aminoaromatischen Chromophors in einem polaren Lösungsmittel mit einem Reinheitsgrad für elektronische Geräte;
2. Filtrieren dieser Lösung;
3. Leiten der filtrierten Lösung durch ein vorher gewaschenes Anionenaustauscherharz, wobei die Fließgeschwindigkeit so gewählt wird, daß die Verweildauer der Lösung im Harz zu einer Herabsetzung des Gehalts an Natrium- und Eisenionen auf jeweils unter 50 ppb führt;
4. Zugabe eines Gießlösungsmittels mit einem Reinheitsgrad für elektronische Geräte, wobei das Verhältnis zwischen dem genannten Gießlösungsmittel und dem genannten polaren Lösungsmittel im Bereich von ca. 1:0,2 bis ca. 1:3 liegt;
5. Abdestillieren des polaren Lösungsmittels mit einem Reinheitsgrad für elektronische Geräte zur Herstellung einer Lösung mit einem geringen Metallgehalt, deren Natrium- und Eisenionenkonzentration unter jeweils 100 ppb liegt;
(b) ca. sechs- bis achtstündiges Umsetzen der Lösung mit dem geringen Metallgehalt und eines eine Anhydridgruppe enthaltenden Polymers bei einer Temperatur von ca. 120°C bis 160°C zur Herstellung eines Reaktionsprodukts mit einer massegemittelten Molekülmasse von ca. 50 000 bis ca. 2 000 000 und
(c) Versetzen des Reaktionsprodukts mit entionisiertem Wasser, ca. 30- bis 90-minütiges Rühren, Abgießen der Wasserschicht und Abdestillieren des Restwassers, wobei eine reflexionsvermindernde Grundbeschichtungszubereitung mit einem Gehalt an Natrium-und Eisenionen unter jeweils 100 ppb entsteht.

3. Verfahren gemäß Anspruch 1 oder 2, wobei der Gehalt an Natrium- und Eisenionen im Ionenaustauscherharz auf unter jeweils 50 ppb herabgesetzt wird.

4. Verfahren gemäß Anspruch 1 oder 2, wobei der Gehalt an Natrium- und Eisenionen im Ionenaustauscherharz auf unter jeweils 10 ppb herabgesetzt wird.

5. Verfahren gemäß Anspruch 1 oder 2, wobei der Gehalt an Natrium- und Eisenionen in der reflexionsvermindernden Grundbeschichtungszubereitung auf unter jeweils 100 ppb herabgesetzt wird.

6. Verfahren gemäß Anspruch 1 oder 2, wobei der Gehalt an Natrium- und Eisenionen in der reflexionsvermindernden Grundbeschichtungszubereitung auf unter jeweils 50 ppb herabgesetzt wird.

7. Verfahren gemäß Anspruch 1 oder 2, wobei der Gehalt an Natrium- und Eisenionen in der reflexionsvermindernden Grundbeschichtungszubereitung auf unter jeweils 10 ppb herabgesetzt wird.

8. Verfahren gemäß Anspruch 1 oder 2, wobei der aminoaromatische Chromophor aus einer Gruppe gewählt wird, die aus 1-Aminoanthracen, 2- Aminoanthracen, 1-Aminonaphthalin, 2-Aminonaphthalin, N-(2,4-Dinitrophenyl)-1,4-phenylendiamin, p-(2,4-Dinitrophenylazo)-anilin,
p-(4-N,N-Dimethylaminophenylazo)anilin, 4-Amino-2-(9-(6-hydroxy-3-xanthenonyl))-benzoesäure, 2,4-Dinitrophenylhydrazin, Dinitroanilin, Aminobenzothiazolin und Amino-fluorenon besteht.

9. Verfahren gemäß Anspruch 1 oder 2, wobei das Polymer aus eine Gruppe gewählt wird, die aus Polydimethylglutarimid, Poly(maleinsäureanhydrid-co-methylmethacrylat), Poly-(maleinsäureanhydrid-co-vinylmethylether), Poly(styrol-co-maleinsäureanhydrid) und Poly(acrylanhydrid) sowie aus Derivaten, Copolymeren und Verbindungen dieser Substanzen besteht.

10. Verfahren gemäß Anspruch 1 oder 2, wobei der aminochromatische Chromophor 2,4-Dinitrophenyl-1,4-benzoldiamin ist.

11. Verfahren gemäß Anspruch 1 oder 2, wobei das Polymer ein Copolymer von Methylvinylether und Maleinsäureanhydrid ist.

12. Verfahren gemäß Anspruch 1 oder 2, wobei das Gießlösungsmittel mit einem Reinheitsgrad für elektronische Geräte aus einer Gruppe gewählt wird, die aus Cyclohexanon, Cyclopentanon und Butyrolacton besteht.

13. Verfahren gemäß Anspruch 1 oder 2, wobei das polare Lösungsmittel mit einem Reinheitsgrad für elektronische Geräte aus einer Gruppe gewählt wird, die aus Aceton, Methanol, Ethanol und Propanol besteht.

14. Verfahren, bei dem die reflexionsvermindernde Grundbeschichtung gemäß Anspruch 1 oder 2 zusätzlich auf einen Träger aufgebracht und bei dem der Träger zur weitgehenden Entfernung des genannten Gießlösungsmittels erhitzt wird.

15. Verfahren gemäß Anspruch 14, bei dem der beschichtete Träger zusätzlich bei einer Temperatur von ca. 80°C bis ca. 150°C erhitzt wird.

16. Verfahren zur Herstellung eines Halbleitergeräts durch Herstellung einer Photoabbildung auf einem Träger, wobei dieses Verfahren aus folgenden Schritten besteht:
(a)
1. Herstellung einer Lösung eines aminoaromatischen Chromophors in einem Gießlösungsmittel mit einem Reinheitsgrad für elektronische Geräte;
2. Zugabe eines polaren Lösungsmittels mit einem Reinheitsgrad für elektronische Geräte zur Herstellung einer homogenen Lösung, wobei das Verhältnis zwischen dem genannten Gießlösungsmittel und dem genannten polaren Lösungsmittel im Bereich von ca. 1:0,2 bis ca. 1:3 liegt;
3. Filtrieren der homogenen Lösung;
4. Leiten der filtrierten Lösung durch ein vorher gewaschenes Anionenaustauscherharz, wobei die Fließgeschwindigkeit so gewählt wird, daß die Verweildauer der Lösung im Harz zu einer Herabsetzung des Gehalts an Natrium- und Eisenionen auf jeweils unter 50 ppb führt;
5. Abdestillieren des polaren Lösungsmittels mit einem Reinheitsgrad für elektronische Geräte zur Herstellung einer Lösung mit einem geringen Metallgehalt, deren Natrium- und Eisenionenkonzentration unter jeweils 100 ppb liegt;
(b) ca. sechs- bis achtstündiges Umsetzen der Lösung mit dem geringen Metallgehalt und eines eine Anhydridgruppe enthaltenden Polymers bei einer Temperatur von ca. 120°C bis 160°C zur Herstellung eines Produkts mit einer massegemittelten Molekülmasse von ca. 50 000 bis ca. 2 000 000;
(c) Versetzen des Reaktionsprodukts mit entionisiertem Wasser, ca. 30- bis 90-minütiges Rühren, Abgießen der Wasserschicht und Abdestillieren des Restwassers, wobei eine reflexionsvermindernde Grundbeschichtungslösung mit einem Gehalt an Natrium- und Eisenionen unter jeweils 100 ppb entsteht;
(d) Formulieren einer Photoresistzubereitungslösung durch Herstellung eines Gemisches aus
1. einer lichtempfindlichen Komponente in einer für die Photosensibilisierung der Photoresistzubereitung ausreichenden Menge;
2. einem filmbildenden Harz in einer für die Bildung einer weitgehend einheitlichen Photoresistzubereitung ausreichenden Menge und
3. einem Photoresistlösungsmittel;
(e) erste Beschichtung eines Trägers mit der reflexionsvermindernden Grundbeschichtungszubereitung aus (c);
(f) Erwärmen des Trägers bei einer für die weitgehende Entfernung des Gießlösungsmittels mit einem Reinheitsgrad für elektronische Geräte ausreichenden Temperatur;
(g) Beschichten des Trägers mit der Photoresistzubereitung;
(h) Wärmebehandlung des beschichteten Trägers bis das gesamte Photoresistlösungsmittel weitgehend entfernt ist, abbildungsgemäße Belichtung der Photoresistzubereitung und Entwicklung der Photoresistzubereitung mit einem Entwickler und
(i) wahlweise Erwärmen des Trägers entweder unmittelbar vor oder nach der Entwicklung gemäß (h).

17. Verfahren zur Herstellung eines Halbleiters durch Herstellung einer Photoabbildung auf einem Träger, wobei dieses Verfahren aus folgenden Schritten besteht:
(a)
1. Herstellung einer Lösung eines aminoaromatischen Chromophors in einem poloaren Lösungsmittel mit einem Reinheitsgrad für elektronische Geräte;
2. Filtrieren dieser Lösung;
3. Leiten der filtrierten Lösung durch ein vorher gewaschenes Anionenaustauscherharz, wobei die Fließgeschwindigkeit so gewählt wird, daß die Verweildauer der Lösung im Harz zu einer Herabsetzung des Gehalts an Natrium- und Eisenionen auf jeweils unter 50 ppb führt;
4. Zugabe eines Gießlösungsmittels mit einem Reinheitsgrad für elektronische Geräte, wobei das Verhältnis zwischen dem genannten Gießlösungsmittel und dem genannten polaren Lösungsmittel im Bereich von ca. 1:0,2 bis ca. 1:3 liegt;
5. Abdestillieren des polaren Lösungsmittels mit einem Reinheitsgrad für elektronische Geräte zur Herstellung einer Lösung mit einem geringen Metallgehalt, deren Natrium- und Eisenionenkonzentration unter jeweils 100 ppb liegt;
(b) ca. sechs- bis achtstündiges Umsetzen der Lösung mit dem geringen Metallgehalt und eines eine Anhydridgruppe enthaltenden Polymers bei einer Temperatur von ca. 120°C bis 160°C zur Herstellung eines Reaktionsprodukts mit einer massegemittelten Molekülmasse von ca. 50 000 bis ca. 2 000 000;
(c) Versetzen des Reaktionsprodukts mit entionisiertem Wasser, ca. 30- bis 90-minütiges Rühren, Abgießen der Wasserschicht und Abdestillieren des Restwassers, wobei eine reflexionsvermindernde Grundbeschichtungszubereitung mit einem Gehalt an Natrium-und Eisenionen unter jeweils 100 ppb entsteht;
(d) Formulieren einer Photoresistzubereitungslösung durch Herstellung eines Gemisches aus
1. einer lichtempfindlichen Komponente in einer für die Photosensibilisierung der Photoresistzubereitung ausreichenden Menge und
2. einem filmbildenden Harz in einer für die Bildung einer weitgehend einheitlichen Photoresistzubereitung ausreichenden Menge und
3. einem Photoresistlösungsmittel;
(e) erste Beschichtung eines Trägers mit der reflexionsvermindernden Grundbeschichtungszubereitung aus (c);
(f) Erwärmen des Trägers bei einer für die weitgehende Entfernung des Gießlösungsmittels mit einem Reinheitsgrad für elektronische Geräte ausreichenden Temperatur;
(g) Beschichten des Trägers mit der Photoresistzubereitung;
(h) Wärmebehandlung des beschichteten Trägers bis das gesamte Photoresistlösungsmittel weitgehend entfernt ist, abbildungsgemäße Belichtung der Photoresistzubereitung und Entwicklung der Photoresistzubereitung mit einem Entwickler und
(i) wahlweise Erwärmen des Trägers entweder unmittelbar vor oder nach der Entwicklung gemäß (h).

18. Verfahren gemäß Anspruch 16 oder 17, wobei der genannte Träger zusätzlich nach der Belichtung, aber noch vor der Entwicklung bei einer Temperatur von ca. 90°C bis ca. 150°C entweder ca. 30 bis ca. 180 Sekunden lang auf einer Heizplatte oder ca. 15 bis ca. 40 Minuten lang im Trockenofen erwärmt wird.

19. Verfahren gemäß Anspruch 16 oder 17, wobei der genannte Träger zusätzlich nach der Entwicklung bei einer Temperatur von ca. 90°C bis ca. 150°C entweder ca. 30 bis ca. 180 Sekunden lang auf einer Heizplatte oder ca. 15 bis ca. 40 Minuten lang im Trockenofen erwärmt wird.

20. Verfahren gemäß Anspruch 16 oder 17, wobei der genannte Träger einen oder mehrere Bestandteile enthält, welche aus einer Gruppe gewählt werden, die aus Silicium, Aluminium, polymeren Harzen, Siliciumdioxid, dotiertem Siliciumdioxid, Siliciumnitrid, Tantal, Kupfer und Polysilicium besteht.

21. Verfahren gemäß Anspruch 16 oder 17, wobei das filmbildende Harz in der Photoresistzubereitung ein Novolakharz ist, dessen Anteil an der Photoresistzubereitung bei ca. 70 bis ca. 90 Prozent liegt, bezogen auf das Gewicht der Feststoffe.

22. Verfahren gemäß Anspruch 16 oder 17, wobei die lichtempfindliche Komponente ein Ester eines Alkohol- oder Phenolrests und einer Sulfonsäure oder eines Sulfonsäurederivats ist.

23. Verfahren gemäß Anspruch 16 oder 17, wobei die lichtempfindliche Komponente auf Strahlung im Bereich von ca. 200 nm bis ca. 450 nm empfindlich reagiert.

24. Verfahren gemäß Anspruch 16 oder 17, wobei die lichtempfindliche Komponente ein Naphthochinondiazidester einer Substanz ist, welche aus einer Gruppe gewählt wird, die aus Multihydroxybenzophenon, Multihydroxyphenylalkan, Phenololigomeren und aus Gemischen dieser Substanzen besteht.

25. Verfahren gemäß Anspruch 16 oder 17, wobei das filmbildende Harz ein Reaktionsprodukt von Formaldehyd und eines oder mehrerer mehrfach substituierter Phenole ist.

26. Verfahren gemäß Anspruch 16 oder 17, wobei das filmbildende Harz in der Photoresistzubereitung ein Polyhydroxystyrol oder ein Derivat von Polyhydroxystyrol ist.

27. Verfahren gemäß Anspruch 16 oder 17, wobei das Lösungsmittel aus einer Gruppe gewählt wird, die aus Propylenglycolmonoalkylether, Propylenglycolmethyletheracetat, Ethyl-3-ethoxypropionat, Ethyllactat, Gemischen aus Ethyl-3-ethoxypropionat und Ethyllactat, Gemischen aus Ethyl-3-ethoxypropionat und Ethyllactat, Butylacetat, Xylol, Diglyme und Ethylenglycolmonoethyletheracetat besteht.

28. Verfahren gemäß Anspruch 16 oder 17, wobei das Lösungsmittel Propylenglycolmonomethyletheracetat oder Ethyl-3-ethoxypropionat enthält.

## Revendications

1. Procédé de production d'une composition de fond antiréfléchissante ayant de très faibles teneurs en ions métalliques comprenant les étapes consistant :
(a)
1. à fabriquer une solution d'un chromophore aminoaromatique dans un solvant d'enduction de qualité électronique ;
2. à ajouter un solvant polaire de qualité électronique pour fabriquer une solution homogène, dans laquelle le rapport du solvant de qualité électronique d'enduction au solvant polaire de qualité électronique est dans la gamme comprise entre environ 1 : 0,2 à environ 1 : 3 ;
3. à filtrer la solution homogène ;
4. à faire passer la solution filtrée à travers une résine d'échange d'anions pré-lavée, à une vitesse telle que le temps de séjour soit suffisant pour réduire le taux d'ions sodium et de fer à moins de 50 ppb de chaque ;
5. à distiller le solvant polaire de qualité électronique pour donner une solution de faible teneur en métal ayant des teneurs en ions sodium et fer inférieures à 100 ppb de chaque ;
b) à mettre à réagir la solution à faible teneur en métal avec un polymère ayant un groupe anhydride à une température comprise entre 120°C et 160°C environ pendant de 6 à 8 heures environ, pour donner un produit de réaction avec une masse molaire moyenne en masse (chromatographie par perméation de gel) comprise entre environ 50 000 et environ 2 000 000 ; et
c) à ajouter de l'eau désionisée au produit de réaction, à agiter pendant environ de 30 à 90 minutes, à décanter la phase aqueuse, à distiller pour enlever l'eau résiduelle et à produire ainsi une solution d'enduction de revêtement de fond antiréfléchissant ayant des taux en ions sodium et fer inférieurs à 100 ppb de chaque.

2. Procédé de production d'une composition de fond antiréfléchissante ayant de très faibles teneurs en ions métalliques comprenant les étapes consistant :
(a)
1. à fabriquer une solution d'un chromophore aminoaromatique dans un solvant d'enduction de qualité électronique ;
2. à filtrer la solution ;
3. à faire passer la solution filtrée à travers une résine d'échange d'anions pré-lavée à une vitesse telle que le temps de séjour soit suffisant pour réduire le taux d'ions sodium et de fer à moins de 50 ppb de chaque ;
4. à ajouter un solvant d'enduction de qualité électronique, dans lequel le rapport du solvant d'enduction de qualité électronique au solvant polaire de qualité électronique est dans la gamme comprise entre environ 1 : 0,2 à environ 1 : 3 ;
5. à distiller le solvant polaire de qualité électronique pour donner une solution de faible teneur en métal ayant des teneurs en ions sodium et fer inférieures à 100 ppb de chaque ;
b) à mettre à réagir la solution à faible teneur en métal avec un polymère ayant un groupe anhydride à une température comprise entre 120°C et 160°C environ pendant de 6 à 8 heures environ, pour donner un produit de réaction avec une masse molaire moyenne en masse (chromatographie par perméation de gel) comprise entre environ 50 000 et environ 2 000 000 ; et
c) à ajouter de l'eau désionisée au produit de réaction, à agiter pendant environ de 30 à 90 minutes, à décanter la phase aqueuse, à distiller pour enlever l'eau résiduelle et à produire ainsi une solution d'enduction de revêtement de fond antiréfléchissant ayant des taux en ions sodium et fer inférieurs à 100 ppb de chaque.

3. Procédé selon la revendication 1 ou 2 dans lequel le taux d'ions sodium et fer dans la résine échangeuse d'ions est réduit à moins de 50 ppb de chaque.

4. Procédé selon la revendication 1 ou 2 dans lequel le taux d'ions sodium et fer dans la résine échangeuse d'ions est réduit à moins de 10 ppb de chaque.

5. Procédé selon la revendication 1 ou 2 dans lequel le taux d'ions sodium et fer dans la composition de fond antiréfléchissante est réduit à moins de 100 ppb de chaque.

6. Procédé selon la revendication 1 ou 2 dans lequel le taux d'ions sodium et fer dans la composition de fond antiréfléchissante est réduit à moins de 50 ppb de chaque.

7. Procédé selon la revendication 1 ou 2 dans lequel le taux d'ions sodium et fer dans la composition de fond antiréfléchissante est réduit à moins de 10 ppb de chaque.

8. Procédé selon la revendication 1 ou 2 dans lequel le chromophore aminoaromatique est choisi parmi 1-aminoanthracène, le 2-aminoanthracène, le 1-amino-naphtalène, le 2-aminonaphtalène, la N-(2,4-dinitro-phényl)-1,4-benzènediamine, la p-(2,4-dinitrophénylazo)-aniline, la p-(4-N,N-diméthylaminophénylazo) aniline, l'acide 4-amino-2-(9-(6-hydroxy-3-xanthénonyl) -benzoïque, la 2,4-dinitrophénylhydrazine, la dinitroaniline, l'aminobenzothiazoline, et l'aminofluorénone.

9. Procédé selon la revendication 1 ou 2 dans lequel le polymère est choisi parmi le polydiméthylglucarimide, le poly(anhydride maléique-co-méthacrylate de méthyle), le poly(anhydride maléique-co-oxyde de vinyle et de méthyle), le poly (styrène-co-anhydride maléique), et le poly(anhydride acrylique), et les dérivés, les copolymères et les combinaisons de ceux-ci.

10. Procédé selon la revendication 1 ou 2 dans lequel le chromophore aminoaromatique est le 2,4-dinitrophényl-1,4-benzènediamine.

11. Procédé selon la revendication 1 ou 2 dans lequel le polymère est un copolymère d'oxyde de méthyle et de vinyle et d'anhydride maléique.

12. Procédé selon la revendication 1 ou 2 dans lequel le solvant d'enduction de qualité électronique est choisi parmi la cyclohexanone, la cyclopentanone et la butyro-lactone.

13. Procédé selon la revendication 1 ou 2 dans lequel le solvant polaire de qualité électronique est choisi parmi l'acétone, le méthanol, l'éthanol et le propanol.

14. Procédé comprenant en outre les étapes consistant à déposer le revêtement de fond antiréfléchissant selon la revendication 1 ou 2 sur un substrat et à chauffer le substrat pour enlever pratiquement complètement le solvant d'enduction de qualité électronique.

15. Procédé selon la revendication 14 comprenant en outre le chauffage dudit substrat revêtu à une température comprise entre environ 80°C et environ 150°C.

16. Procédé de production d'un dispositif semiconducteur en produisant une image photographique sur un substrat comprenant les étapes consistant :
(a)
1. à fabriquer une solution d'un chromophore amino-aromatique dans un solvant d'enduction de qualité électronique ;
2. à ajouter un solvant polaire de qualité électronique pour fabriquer une solution homogène, dans laquelle le rapport du solvant d'enduction de qualité électronique au solvant polaire de qualité électronique est dans la gamme comprise entre environ 1 : 0,2 à environ 1 : 3 ;
3. à filtrer la solution homogène ;
4. à faire passer la solution filtrée à travers une résine d'échange d'anions pré-lavée, à une vitesse telle que le temps de séjour soit suffisant pour réduire le taux d'ions sodium et fer à moins de 50 ppb de chaque ;
5. à distiller le solvant polaire de qualité électronique pour donner une solution de faible teneur en métal ayant des teneurs en ions sodium et fer inférieures à 100 ppb de chaque ;
(b) à mettre à réagir la solution à faible teneur en métal avec un polymère ayant un groupe anhydride à une température comprise entre environ 120°C et 160°C pendant environ de 6 à 8 heures, pour donner un produit de réaction avec une masse molaire moyenne en masse comprise entre environ 50 000 et environ 2 000 000 ;
(c) à ajouter de l'eau désionisée au produit de réaction, à agiter pendant de 30 à 90 minutes environ, à décanter la phase aqueuse, à distiller pour enlever l'eau résiduelle et à produire ainsi une solution d'enduction de revêtement de fond antiréfléchissant ayant des teneurs en ions sodium et fer inférieures à 100 ppb de chaque ;
(d) à formuler une solution de composition de photoresist en réalisant un mélange :
1. d'un composant photosensible en une quantité suffisante pour photosensibiliser la composition de photoresist,
2. d'une résine filmogène en une quantité suffisante pour préparer une composition de photoresist essentiellement homogène, et
3. d'un solvant de photoresist ;
(e) à revêtir d'abord un substrat avec la composition de revêtement antiréfléchissant de fond provenant de (c) ;
(f) à chauffer le substrat à une température suffisante pour enlever pratiquement complètement le solvant d'enduction de qualité électronique ;
(g) à enduire le substrat avec la composition de photoresist ;
(h) à traiter thermiquement le substrat revêtu jusqu'à ce que pratiquement tout le solvant du photoresist soit enlevé, à exposer la composition de photoresist selon une image et à développer la composition de photoresist avec un révélateur; et
(i) à éventuellement chauffer le substrat soit immédiatement avant ou après l'étape de développement de (h).

17. Procédé de production d'un dispositif semiconducteur en produisant une image photographique sur un substrat comprenant les étapes consistant :
(a)
1. à fabriquer une solution d'un chromophore aminoaromatique dans un solvant d'enduction de qualité électronique ;
2. à filtrer la solution ;
3. à faire passer la solution filtrée à travers une résine d'échange d'anions pré-lavée à une vitesse telle que le temps de séjour soit suffisant pour réduire le taux d'ions sodium et de fer à moins de 50 ppb de chaque ;
4. à ajouter un solvant d'enduction de qualité électronique, dans lequel le rapport du solvant d'enduction de qualité électronique au solvant polaire de qualité électronique est dans la gamme comprise entre environ 1 : 0,2 à environ 1 : 3 ;
5. à distiller le solvant polaire de qualité électronique pour donner une solution de faible teneur en métal ayant des teneurs en ions sodium et fer inférieures à 100 ppb de chaque ;
(b) à mettre à réagir la solution à faible teneur en métal avec un polymère ayant un groupe anhydride à une température comprise entre environ 120°C et 160°C pendant environ de 6 à 8 heures, pour donner un produit de réaction avec une masse molaire moyenne en masse comprise entre environ 50 000 et environ 2 000 000 ;
(c) à ajouter de l'eau désionisée au produit de réaction, à agiter pendant de 30 à 90 minutes environ, à décanter la phase aqueuse, à distiller pour enlever l'eau résiduelle et à produire ainsi une solution d'enduction de revêtement de fond antiréfléchissant ayant des teneurs en ions sodium et fer inférieures à 100 ppb de chaque ;
(d) à formuler une solution de composition de photoresist en réalisant un mélange :
1. d'un composant photosensible en une quantité suffisante pour photosensibiliser la composition de photoresist,
2. d'une résine filmogène en une quantité suffisante pour préparer une composition de photoresist essentiellement homogène, et
3. d'un solvant de photoresist ;
(e) à revêtir d'abord un substrat avec la composition de revêtement antiréfléchissant de fond provenant de (c) ;
(f) à chauffer le substrat à une température suffisante pour enlever pratiquement complètement le solvant d'enduction de qualité électronique ;
(g) à enduire le substrat avec la composition de photoresist ;
(h) à traiter thermiquement le substrat revêtu jusqu'à ce que pratiquement tout le solvant du photoresist soit enlevé, à exposer la composition de photoresist selon une image et à développer la composition de photoresist avec un révélateur; et
(i) à éventuellement chauffer le substrat soit immédiatement avant ou après l'étape de développement de (h).

18. Procédé selon la revendication 16 ou 17 comprenant en outre le chauffage dudit substrat revêtu à une température comprise entre environ 90°C et environ 150°C pendant d'environ 30 secondes à environ 180 secondes sur une plaque chauffante ou pendant environ 15 minutes à environ 40 minutes dans une étuve après l'étape d'exposition mais avant l'étape de développement.

19. Procédé selon la revendication 16 ou 17 comprenant en outre le chauffage dudit substrat revêtu à une température comprise entre environ 90°C et environ 150°C pendant d'environ 30 secondes à environ 180 secondes sur une plaque chauffante ou pendant environ 15 minutes à environ 40 minutes dans une étuve après l'étape de développement.

20. Procédé selon la revendication 16 ou 17 dans lequel ledit substrat comprend un ou plusieurs composants choisis parmi le silicium, l'aluminium, les résines polymériques, le dioxyde de silicium, le dioxyde de silicium dopé, le nitrure de silicium, le tantale, le cuivre et le polysilicium.

21. Procédé selon la revendication 16 ou 17 dans lequel la résine filmogène dans la composition de photoresist est une résine novolaque et la quantité dans la composition de photoresist est comprise dans la gamme comprise entre environ 70 pour cent et environ 90 pour cent, sur la base du poids des matières solides.

22. Procédé selon la revendication 16 ou 17 dans lequel le composé photosensible est un ester d'un résidu alcoolique ou phénolique et d'un acide sulfonique ou d'un dérivé d'acide sulfonique.

23. Procédé selon la revendication 16 ou 17 dans lequel le composé photosensible est sensible au rayonnement dans la gamme comprise entre environ 200 nm et environ 450 nm.

24. Procédé selon la revendication 16 ou 17 dans lequel le composé photosensible est un ester naphtoquinone diazide d'un composé choisi parmi la multihydroxybenzophénone, un multihydroxyphénylalcane, des oligomères phénoliques, et des mélanges de ceux-ci.

25. Procédé selon la revendication 16 ou 17 dans lequel la résine filmogène est un produit de réaction de formaldéhyde avec un ou plusieurs phénols plurisubstitués.

26. Procédé selon la revendication 16 ou 17 dans lequel la résine filmogène dans la composition de photoresist est un polyhydroxystyrène ou ses dérivés.

27. Procédé selon la revendication 16 ou 17 dans lequel le solvant est choisi parmi l'éther monoalkylique de propylèneglycol, l'éther monométhylique de propylèneglycol acétate, le 3-éthoxypropionate d'éthyle, le lactate d'éthyle, les mélanges de 3-éthoxypropionate d'éthyle et de lactate d'éthyle, l'acétate de butyle, le xylène, le diglyme et l'éther monoéthylique d'éthylèneglycol acétate.

28. Procédé selon la revendication 16 ou 17 dans lequel le solvant comprend l'éther monométhylique de propylèneglycol acétate ou le 3-éthoxypropionate d'éthyle.
